# EUROPÄISCHE PATENTSCHRIFT

(11) **EP 0 910 683 B1**
(45) Veröffentlichungstag und Bekanntmachung des Hinweises auf die Patenterteilung: **02.02.2000**
(21) Anmeldenummer: 97931806.0
(22) Anmeldetag: 10.07.1997
(51) Int. Cl.: C23C 14/28, C23C 14/32, C23C 14/56

(54) **VAKUUMBESCHICHTUNGSANLAGE MIT EINER BESCHICHTUNGSKAMMER UND ZUMINDEST EINER QUELLENKAMMER**
VACUUM COATING SYSTEM WITH A COATING CHAMBER AND AT LEAST ONE SOURCE CHAMBER
SYSTEME DE REVETEMENT SOUS VIDE COMPORTANT UNE CHAMBRE DE REVETEMENT ET AU MOINS UNE CHAMBRE DE SOURCE

(30) Priorität: 12.07.1996 DE 19628102
(43) Veröffentlichungstag der Anmeldung: 28.04.1999
(73) Patentinhaber: Bayerische Motoren Werke Aktiengesellschaft, 80788 München (DE); FRAUNHOFER-GESELLSCHAFT ZUR FÖRDERUNG DER ANGEWANDTEN FORSCHUNG E.V., 80636 München (DE)
(72) Erfinder: SCHEIBE, Hans-Joachim, D-01277 Dresden (DE); GIERSCH, Daniela, D-80999 München (DE); SCHALAUSKY, Robert, D-82343 Pöcking (DE); MIELSCH, Götz, D-80935 München (DE)
(74) Vertreter: König, Heinz
(86) Internationale Anmeldenummer: EP9703653
(87) Internationale Veröffentlichungsnummer: WO9802596

(56) Entgegenhaltungen:
- EP-A- 0 158 972
- DD-A- 279 695
- DE-C- 4 342 574
- US-A- 3 649 339
- PATENT ABSTRACTS OF JAPAN vol. 005, no. 132 (C-068), 22.August 1981 & JP 56 065981 A (HITACHI LTD), 4.Juni 1981,
- PATENT ABSTRACTS OF JAPAN vol. 007, no. 100 (C-164), 28.April 1983 & JP 58 025474 A (MITSUBISHI DENKI KK), 15.Februar 1983,

## Beschreibung

Die Erfindung betrifft eine Vakuumbeschichtungsanlage mit einer evakuierbaren Beschichtungskammer für ein zu beschichtendes Substrat, und mit zumindest einer hiermit in Verbindung stehenden Quellenkammer für eine Materialquelle für das Beschichtungsmaterial. Zum bekannten Stand der Technik wird neben der DD 279 695 A1 insbesondere auf die EP-A-0 158 972 oder die DE-C-43 42 574 verwiesen.

Bei der aus der erstgenannten Schrift bekannten Vakuumbeschichtungsanlage befindet sich sowohl das zu beschichtende Substrat, als auch eine Materialquelle für das Beschichtungsmaterial im wesentlichen in einem gemeinsamen evakuierbaren Raum, der lediglich durch eine sog. Blende, die zur gezielten Führung des dampfförmigen Beschichtungsmateriales vorgesehen ist, quasi unterteilt wird in eine sog. Beschichtungskammer, in welcher sich das Substrat befindet, und in eine sog. Quellenkammer, in der sich die Materialquelle für das Beschichtungsmaterial befindet. Diese beiden Kammern des im bekannten Stand der Technik einzigen Raumes werden gemeinsam evakuiert, um das für den Beschichtungsvorgang erforderliche Vakuum zu erzeugen, werden aber auch gemeinsam belüftet, wenn das zu beschichtende Substrat nach Abschluß des Beschichtungsvorganges aus der Vakuumbeschichtungsanlage entnommen wird. Dies ist jedoch nachteilig, da dabei die Materialquelle für das Beschichtungsmaterial mit Umgebungsluft in Kontakt kommt und hierbei verunreinigt werden kann, beispielsweise durch den Niederschlag von Luftfeuchtigkeit, wie an späterer Stelle noch näher erläutert wird.

Ein weiterer Nachteil, der sich aus der gemeinsamen Anordnung des zu beschichtenden Substrates sowie der Materialquelle im wesentlichen in einem gemeinsamen evakuierbaren Raum ergibt, tritt dann auf, wenn sich während des Beschichtungsprozesses an der Materialquelle für das Beschichtungsmaterial irgendwelche Störungen einstellen. Beispielsweise kann es erforderlich sein, diese Materialquelle auszutauschen, obwohl der Beschichtungsprozeß noch nicht vollständig abgeschlossen ist. Dann muß die Vakuumbeschichtungsanlage zwangsläufig geöffnet und somit belüftet werden, wodurch jedoch der bereits begonnene Beschichtungsprozeß gestört wird und das bis zu diesem Zeitpunkt nur teilweise beschichtete Substrat somit unbrauchbar wird.

Besonders nachteilig ist jedoch der bekannte Stand der Technik im Zusammenhang mit der Abscheidung von Multischichten, d. h. von mehreren Schichtlagen unterschiedlichen Materials auf einem zu beschichtenden Substrat, wobei auch unterschiedliche Materialquellen benötigt werden.

Für diese Abscheidung von Multischichten in Kombination mit amorphen Kohlenstoffschichten ist ein lasergezündeter Vakuum-Bogenentladungsverdampfer aus der DD 279 695 A1 bekannt, bei dem die zu verdampfenden Materialien scheibenförmig auf einer rotierenden walzenförmigen Kathode aufgebracht sind, die an beliebiger Stelle im Verhältnis zum zu beschichtenden Substrat im Vakuumrezipienten angeordnet ist.

Nachteilig an dieser Anordnung ist, daß sich die aus unterschiedlichen Materialien bestehende Kathode im gemeinsamen Raum bzw. in der Beschichtungskammer befindet und somit trotz geeigneter Abschirmvorrichtungen nicht verhindert werden kann, daß die passiven Materialien der walzenförmigen Kathode durch Kondamination so verunreinigt werden, daß die Reinheit der abgeschiedenen Schichten bzw. Schichtfolgen nicht gewährleistet werden kann.

Ein weiterer Nachteil besteht darin, daß durch den unterschiedlichen Abtrag der einzelnen Kathodenmaterialien der Kathoden-Anoden-Abstand so ungleichmäßig verändert wird, daß keine gleichbleibend stabilen Zündbedingungen bei allen Materialien für langandauernde Beschichtungszyklen unter realistischen, insbesondere Serien-Produktionsbedingungen gewährleistet werden kann. Um diese Zündbedingungen zu garantieren, ist ein aufwendiges mechanisches Abdrehen der Kathodenwalze erforderlich, wodurch der Grad der Ausnutzung des Kathodenmaterials beträchtlich sinkt.

Ein weiterer Nachteil ergibt sich aus den begrenzten Auslenkungsmöglichkeiten eines Laserstrahls, unter denen die Fokalebene auf einem Target (hier handelt es sich um die Kathode bzw. die Materialquelle für das Beschichtungsmaterial) garantiert werden kann. Dadurch wird die Länge eines Targets (Kathode) bestimmt, so daß bei einer aus unterschiedlichen Materialien aufgebauten Kathode keine Bedingungen zur homogen Abscheidung dieser Materialen auf großflächigen Substraten ohne zusätzliche aufwendige Substratbewegungen gewährleistet werden können.

Ein weiterer Nachteil der Kathodenanordnung im gemeinsamen Raum bzw. in der Beschichtungskammer ergibt sich durch notwendige Belüftungszyklen beim Substratwechsel. Dadurch daß das Kathodenmaterial in Kontakt mit der Raumatmosphäre kommt, kann sich insbesondere Wasser (Luftfeuchtigkeit) auf der Kathodenoberfläche niederschlagen. Das ist bei Graphit aufgrund seiner Porosität (~ 8 %) gegenüber Metallen besonders dramatisch, da bei diesem analog zur Aktivkohle z.B. Wasser eingelagert und gespeichert wird. Somit kann keine gleichbleibende Schichtqualität hochwertiger amorpher Kohlenstoffschichten gewährleistet werden, da insbesondere beim Beginn des Beschichtungsprozesses Wasserstoff und Sauerstoff freigesetzt und in die abgeschiedene Schicht mit eingebaut werden. Durch den Einbau von Wasserstoff wird nachweislich die Härte amorpher Kohlenstoffschichten herabgesetzt. Zur Verhinderung eines derartigen Wasserstoffeinbaus in die Schicht wird vor Beginn der Abscheidung ein zusätzliches Ausheizen der Kathode erforderlich. Wasser sollte nämlich prinzipiell bei der Niedrigtemperaturbeschichtung (< 100°C) vermieden werden, da dieses als Ursache unzureichender Haftung und daraus resultierender Schichtablösungen nachgewiesen wurde.

Nun sind zwar bereits Vakuumbeschichtungsanlagen bekannt, bei denen die Beschichtungskammer von der Quellenkammer vakkumdicht trennbar ist, wobei dann zumindest einige der eingangs genannten Nachteiie nicht mehr vorliegen, jedoch gibt dieser bekannte Stand der Technik, so beispielsweise die eingangs genannten DE-C-43 42 574 oder EP-A-0 158 972 keine Hinweise für eine Vakuumbeschichtungsanlage, mit welcher verschiedene Beschichtungsmaterialien auf ein zu beschichtendes Substrat aufgebracht werden können.

Aufgabe der Erfindung ist es daher, eine Vakuumbeschichtungsanlage nach dem Oberbegriff des Ansruchs 1 aufzuzeigen, mit welcher unter Vermeidung der oben geschilderten Nachteile unter den Bedingungen einer Serienproduktion auf großflächigen zu beschichtenden Bauteilen (Substraten) Multischichten bestehend aus mindestens zwei unterschiedlichen Materialien homogen effektiv abgeschieden werden können.

Zur Lösung dieser Aufgabe sind die kennzeichnenden Merkmale des Patentanspruches 1 vorgesehen. Vorteilhafte Weiterbildungen sind Inhalt der Unteransprüche.

Nach einem bevorzugten Ausführungsbeispiel der Erfindung sind dabei zwei verschiedene Quellenkammern vorgesehen, wobei die Beschichtungskammer evakuiert werden oder auch bleiben kann, wenn eine einzelne Quellenkammer belüftet oder gegen eine andere Quellenkammer ausgetauscht wird. Mittels einer geeigneten Vorrichtung und Anordnung eines lasergesteuerten Vakuum-Bogenverdampfers sollen somit auf großflächigen Bauteilen (Substraten) homogene Multischichten effektiv abgeschieden werden können, wobei eine hohe Betriebssicherheit des Verdampfers bei einer guten Ausnutzung des Kathodenmaterials gewährleistet werden soll.

Erfindungsgemäß ist - wie angegeben - die Beschichtungskammer, in der sich das zu beschichtende Substrat befindet, von den für sich evakuierbaren Quellenkammern, in denen sich bevorzugt jeweils eine Materialquelle für das Beschichtungsmaterial befindet, vakuumdicht trennbar. Dies bedeutet, daß entweder die Beschichtungskammer zugängig ist, ohne daß hierbei eine der Quellenkammern belüftet wird, oder daß eine oder alle Quellenkammern zugängig ist/sind, ohne daß hierbei die Beschichtungskammer belüftet wird. Möglich ist dies, indem für das zu beschichtende Substrat sowie für die Materialquelle für das Beschichtungsmaterial jeweils eine separate Kammer angebracht ist, wobei die für den Beschichtungsprozeß erforderliche Verbindung zwischen diesen beiden Kammern unterbrechbar ist. Selbstverständlich ist es in diesem Zusammenhang erforderlich, jede Kammer für sich evakuierbar auszubilden, d. h. sowohl in der Beschichtungskammer als auch in der jeweiligen Quellenkammer kann jeweils separat ein Vakuum erzeugt werden. Sowohl für die Entnahme des Substrats als auch für den Austausch der Materialquelle in der Beschichtungskammer können somit diese beiden Kammern voneinander getrennt werden, beispielsweise unter Zuhilfenahme eines üblichen, insbesondere trennwandförmigen Plattenventiles.

Um nun verschiedene Beschichtungsmaterialien auf das Substrat aufzubringen, ist für jedes Beschichtungsmaterial bzw. für die zugehörige Materialquelle eine separate sog. Quellenkammer angebracht. Die Beschichtungskammer ist dann nacheinander auf einfache Weise mit verschiedenen Quellenkammern verbindbar, was insbesondere für eine Serienfertigung, d.h. für eine industrielle Großserien-Beschichtung von Substraten besonders vorteilhaft ist. Dies wird im folgenden für den bevorzugten Anwendungsfall, nämlich für die Beschichtung mittels eines lasergesteuerten Vakuum-Bogenverdampfers, wobei jede Materialquelle auf einer rotierbaren Kathode und jede solche in einer separaten Quellenkammer angeordnet ist, ausführlicher erläutert:

Hierbei wird jede zu verdampfende Materialart in Form einer walzenförmigen rotierenden Kathode in einer gesonderten Quellenkammer untergebracht, wobei die einzelnen Quellenkammern sequentiell evakuierbar sind und durch Plattenventile vakuumdicht abgeschlossen werden können. Ausdrücklich sei hierbei darauf hingewiesen, daß bei Vorhandensein bspw. zweier Quellenkammern nur eine dieser beiden Quellenkammern bevorzugt mit Hilfe eines eigenen, dieser Quellenkammer zugeordneten Vakuumsystemes auch nur diese Quellenkammer evakuuiert werden kann, während an der anderen Quellenkammer bspw. das Kathodenmaterial ausgetauscht werden kann.

Bevorzugt werden diese Quellenkammern an geeigneten Positionen der Beschichtungskammer derart angeflanscht, daß das Kathodenmaterial der Quellenkammer, deren Plattenventil geöffnet wurde, homogen und mit hoher Reinheit auf einem großflächigen Bauteil/Substrat abgeschieden wird. Nach Erreichen der gewünschten Schichtdicke auf dem Substrat wird das entsprechende Plattenventil geschlossen und die nächste Schicht, bestehend aus dem Material einer zweiten Quellenkammer nach Öffnen des entsprechenden Plattenventils abgeschieden. Es ist stets nur das Plattenventil derjenigen Quellenkammer geöffnet, aus der gerade Material verdampft wird, so daß die Reinheit des Materials in den anderen Quellenkammern unverändert bleibt.

Bei Belüftung der Beschichtungskammer zum Substratwechsel bleiben alle Quellenkammern vakuumdicht verschlossen, so daß keine Luftfeuchtigkeit oder Verunreinigungen sich auf den Kathoden niederschlagen kann.

Zu Wartungszwecken bzw. zum Austausch der Materialquelle kann jede Quellenkammer für sich von außen zugängig sein, beispielsweise über einen entfernbaren Wandabschnitt des entsprechenden Quellenkammer-Gehäuses. Auch kann das Quellenkammer-Gehäuse mit dem Gehäuse der Beschichtungskammer lösbar verbunden sein, wodurch bei geeigneter geometrischer Abstimmung an einer Stelle der Beschichtungskammer wahlweise verschiedene Quellenkammer-Gehäuse befestigt werden können oder ein bestimmtes Quellenkammer-Gehäuse nacheinander auch verschiedenen Beschichtungskammern zugeordnet werden kann. Insbesondere können derartige anflanschbare Quellenkammer-Gehäuse auch an einer Fließ-Beschichtungsanlage mit verschiedenen Beschichtungskammern, die durch Druckschleusen voneinander getrennt sein können, und die beispielsweise in der DE 44 38 608 C2 beschrieben ist, vorgesehen sein.

Der Beschichtungsprozeß selbst ist durch die typischen Merkmale des lasergesteuerten Vakuum-Bogens geprägt. Mit einem gepulsten Hochleistungslaser, der mit seinen Parametern stabil eine Leistungsdichte von 10⁸ Wcm⁻² im Fokus gewährleistet, wird der Vakuumbogen auf der Kathodenoberfläche gezündet. Durch die mit der Kathode und der Anode verknüpfte Impulsstromquelle wird die Brenndauer des Bogens, die Materialerosion und die Plasmaeigenschaften bestimmt. Durch die lineare Laserstrahloszillation und die Rotationsbewegung der Kathodenwalze wird ein systematischer und gleichmäßiger Abtrag der gesamten Kathodenoberfläche gewährleistet. Durch Anpassung der Kathodenlänge an die Substratabmessungen und durch eine einfache lineare oder rotierende Substratbewegung wird eine homogene Beschichtung der gesamten Substratoberfläche erreicht.
Für die effektive Abscheidung von Multischichten werden mindestens zwei Quellenkammern an eine Beschichtungskammer angeflanscht, deren Kathodenwalzen jeweils mit Beschichtungsmaterial bestückt sind. In diesem Zusammenhang sei darauf hingewiesen, daß selbstverständlich auf einer Kathodenwalze unterschiedliche Materialien vorgesehen sein können. Beispielsweise können hintereinander bspw. gestapelt Scheiben aus Aluminium, Titan und Kohlenstoff abwechselnd auf der Kathodenwalze angeordnet sein.

Eine derartige Quellkammer kann aber auch anstelle eines Targets einer Magnetronsputteranlage angeflanscht werden, so daß z.B. unmittelbar auf eine mit dem Magnetron aufgebrachte Schicht eine superharte amorphe Kohlenstoffschicht mit dem lasergesteuerten Vakuumbogen aufgebracht werden kann.

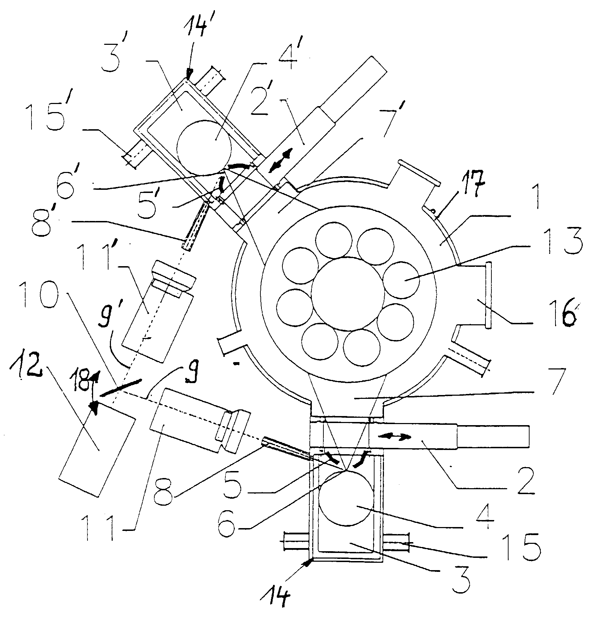

Die Erfindung soll nachfolgend an einem Ausführungsbeispiel näher erläutert werden. In der beigefügten Zeichnung ist eine erfindungsgemäße Anordnung eines lasergesteuerten Vakuum-Bogenbeschichtungsverdampers mit zwei sequentiell evakuierbaren Quellenkammern dargestellt.

In einer über einen Pumpstutzen (16) evakuierbaren Vakuum-Beschichtungskammer (1) befindet sich bevorzugt in deren Mitte ein drehbarer, wasserkühlbarer und mit einer Bias-Spannung beaufschlagbarer nicht näher bezeichneter Substrathalter, auf welchem zumindest ein zu beschichtendes Substrat (13) angeordnet ist. Hier sind auf einem Drehtisch kreisförmig auf wiederrum in sich über ein Planetengetriebe drehbaren Substrathaltern mehrere zu beschichtende Substrate (13) in der Beschichtungskammer (1) angeordnet, so daß diese meheren Substrate (13) sequentiell nacheinander beschichtet werden können, ohne dazwischen die Beschichtungskammer (1) öffnen und dabei belüften sowie nach Einsetzen weiterer Substrate wieder evakuieren zu müssen.

An der Beschichtungskammer (1) bzw. am Gehäuse (17) derselben sind im rechten Winkel zueinander zwei Quellenkammern (3, 3') angeflanscht. Diese weisen jeweils ein Quellenkammer-Gehäuse (14, 14') auf, in welchem jeweils ein Pumpstutzen (15, 15') für die Evakuierung der Quellenkammern (3, 3') vorgesehen ist.
Mittels jeweils eines gemäß dargestellter Pfeilrichtung bewegbaren Plattenventiles (2, 2') sind die Quellenkammern (3, 3') vakuumdicht von der Beschichtungskammer (1) trennbar bzw. durch Öffnen des jeweiligen Plattenventiles (2, 2') selektiv mit der Beschichtungskammer (1) verbindbar. Mit Hilfe eines Pumpstandes, bestehend aus einer Vorvakuum- und einer Hochvakuumpumpe (z.B. Turbomolekularpumpe) wird in den Quellenkammern (3, 3') über die Pumpstutzen (15, 15') bei geschlossenen Plattenventilen (2, 2'), unabhängig voneinander und auch unabhängig von der Beschichtungskammer (1) ein Vakuum von ca. 10⁻⁴ Pa erzeugt.

Eine in der ersten Quellenkammer (3) angeordnete als Materialquelle fungierende walzenförmige Kathode (4) besteht beispielsweise aus hochreinem Elektrodengraphit, während eine in der zweiten Quellenkammer (3') befindliche als weitere Materialquelle fungierende Kathode (4') aus hochreinem Aluminium gefertigt ist.

Bestandteil der Quellenkammer-Gehäuse (14, 14') sind nicht näher bezeichnete, zum Innenraum jeder Quellenkammer (3, 3') offene Lichtkanalstutzen, die endseitig jeweils von einem Fenster (8, 8') vakuumdicht verschlossen sind. Durch diese somit an den Quellenkammern (3, 3') an geeigneter Stelle angebrachten Fenster (8, 8') wird der Strahl (9, 9') eines gepulsten Nd-YAG-Lasers (12) zur Zündung und Führung eines Vakuumbogens auf eine der beiden Kathoden (4, 4') gelenkt.
Der Strahl (9, 9') des als lmpulslaser arbeitenden Nd-YAG-Lasers (12) kann dabei über einen gemäß Pfeilrichtung (18) verschwenkbaren Umlenkspiegel (10) wahlweise in die Quellenkammer (3) oder (3') geführt werden. Durch jeweils vor den Eintritts-Fenstern (8, 8') angeordneten Planfeldobjektive (11, 11') erfolgt die Fokusierung des Laserstrahls (9, 9') auf den für die Bogenzündung erforderlichen Punkt auf der Oberfläche der Kathode (4 oder 4') und dessen Auslenkung linear über die gesamte Kathodenlänge. Bei diesen Planfeldobjektiven (11, 11') handelt es sich somit um eine sog. Fokusier- und Ablenkoptik.

Die bevorzugten Laserparameter können wie folgt sein:
Wellenlänge 1,06µm, Impulslänge 90ns (Halbwertsbreite), Pulsenergie >15mJ, so daß im Fokus stabil Leistungsdichten >5•10⁸ Wcm⁻², dem Schwellwert für die Plasmaerzeugung, bei Wiederhol- oder Folgefrequenzen bis zu 1kHz erreicht werden.

In den Quellenkammern (3, 3') sind ca. 5 mm oberhalb der Kathoden (4, 4') Anoden (5, 5') so angeordnet, daß durch das laserinduzierte Zündplasma (6, 6') stabile Zündbedingungen für einen Lichtbogen und damit stabile Ausbreitungsbedingungen für das jeweilige bogeninduzierte Beschichtungsplasma (7, 7'), d. h. für das abgegebene Beschichtungsmaterial gegeben sind. Kathode (4, 4') und Anode (5, 5') sind mit einer gepulsten Stromquelle verbunden, die bspw. einen maximalen Bogenstrom von 1,5 kA bei einer Brennspannung von ca. 60 V, bei einer lmpulslänge von 100 µs und bei einer Wiederholfrequenz von 1 kHz stabil gewährleistet.

Nachdem in der Beschichtungskammer (1) zumindest ein entsprechendes Substrat (13) auf dem Substrathalter angebracht wurde, wobei die zu beschichtende Oberfläche durch einen üblichen Reinigungsprozeß, z.B. durch einen Glimmprozeß (Sputtern mit Argonionen), vorbehandelt wurde, wird mit Hilfe des bereits erwähnten Pumpstandes über den Pumpstutzen (16) auch in der Beschichtungskammer (1) ein Arbeitsdruck von 10⁻⁴ Pa erzeugt. Nach Erreichen des Arbeitsdruckes wird das erste Plattenventil (2') geöffnet und mit der Abscheidung von Aluminium begonnen, indem der Laserstrahl (9') über den Umlenkspiegel (10) auf die Kathode (4') gelenkt und linear über die gesamte Kathodenlänge geführt wird. Nach Erreichen der gewünschten Schichtdicke von 20 nm auf der gesamten Substratoberfläche, was bei kalibrierter Anordnung durch Zählung der Bogenimpulse kontrolliert wird, wird das Plattenventil (2') geschlossen und der Laserstrahl (9) durch Verschwenken des Umlenkspiegels (10) auf die zweite Kathode (4) gespiegelt. Mit dem Öffnen des dieser Quellenkammer (3) zugeordneten Plattenventiles (2) wird auf der Substratoberfläche eine 20 nm dicke amorphe Kohlenstoffschicht bei entsprechender lmpulswahl abgeschieden, dabei ist nunmehr die Quellenkammer (3) aktiviert, nachdem zunächst die Quellenkammer (3') aktiviert war. Durch Wiederholung der entsprechenden Zyklen, wird eine Multischicht bestehend aus Aluminium und amorphem Kohlenstoff mit einer Gesamtschichtdicke von 2µm und Einzelschichtdicken von 20nm und 100 Einzelschichtpaaren abgeschieden. Je nach Wahl der Anzahl der Bogenimpulse für das jeweilige Material und der entsprechenden Zyklen kann der Schichtaufbau, Einzel- und Gesamtschichtdicke beliebig variiert werden.

Beim Belüften der Beschichtungskammer (1) zum Wechseln des bzw. der Substrate(s) (13) können vorteilhafterweise die Quellenkammern (3, 3') unter Hochvakuum verbleiben.

Abweichend vom gezeigten Ausführungsbeispiel ist es jedoch auch möglich, das Beschichtungsmaterial in einer Quellenkammer durch Magnetronsputtern zu erzeugen. So ist es beispielsweise möglich, an einer Magnetronsputteranlage, die vier jeweils um 90 Grad versetzte Magnetrons enthält, eines dieser Magnetrons durch eine Quellenkammer mit einer Kohlenstoffwalze zu ersetzen. Mit dem bekannten Magnetronsputterprozeß kann auf das in der Kammermitte rotierend angeordnete ebene Substrat (13) ein Schichtsystem Ti, TiN, TiCN, TiC mit jeweiligen Einzelschichtdicken von 500nm aufgebracht werden. Anschließend wird die Beschichtungskammer (13) auf einen Druck von 10⁻⁴ Pa evakuiert. Nach Öffnen des Plattenventils (2) der Quellenkammer (3) wird mit dem lasergesteuerten Vakuumbogen analog zur bereits erläuterten Prozeßfolge eine 300nm dicke Schicht aus superhartem amorphen Kohlenstoff aufgebracht. Jedoch kann dies sowie eine Vielzahl weiterer Details durchaus abweichend hiervon und insbesondere auch abweichend vom gezeigten Ausführungsbeispiel gestaltet sein, ohne den Inhalt der Patentansprüche zu verlassen.

### Bezugszeichenliste:

- 1: Vakuum-Beschichtungskammer

- 2, 2': erstes bzw. zweites Plattenventil
- 3, 3': erste bzw. zweite Quellenkammer

- 4, 4': erste bzw. zweite als Materialquelle fungierende Kathode
- 5, 5': erste bzw. zweite Anode

- 6, 6': (jeweiliges) laserinduziertes Zündplasma
- 7, 7': (jeweiliges) bogeninduziertes Beschichtungsplasma

- 8, 8': Fenster an 3, 3'
- 9, 9': Strahl eines Lasers, der in 3 bzw. 3' gelangt

- 10: Umlenkspiegel
- 11, 11': erstes bzw. zweites Planfeldobjektiv
- 12: Laser

- 13: zu beschichtendes Substrat
- 14, 14': erstes bzw. zweites Quellenkammer-Gehäuse
- 15, 15': Pumpstutzen von 3, 3'

- 16: Pumpstutzen von 1
- 17: Gehäuse von 1
- 18: Pfeilrichtung: Verschwenken von 10

## Patentansprüche

1. Vakuumbeschichtungsanlage mit einer evakuierbaren Beschichtungskammer (1) für ein zu beschichtendes Substrat (13), und mit zumindest einer hiermit in Verbindung stehenden Quellenkammer (3, 3') für eine Materialquelle (Kathode 4) für das Beschichtungsmaterial, dadurch gekennzeichnet, daß die Beschichtungskammer (1) von den für verschiedene Beschichtungsmaterialien angebrachten mehreren, jeweils für sich evakuierbaren Quellenkammern (3, 3') vakuumdicht trennbar ist,
wobei das Beschichtungsmaterial in der Quellenkammer (3, 3') durch eine gepulst betreibbare Bogenentladung verdampfbar ist,
wofür ein einziger Laser (12) angebracht ist, dessen Laserstrahl (9, 9') über einen verschwenkbaren Umlenkspiegel (10) zur jeweils zu aktivierenden Quellenkammer (3, 3') und in dieser über die kathodische Materialquelle (Kathode 4) führbar ist.

2. Vakuumbeschichtungsanlage nach Anspruch 1,
dadurch gekennzeichnet, daß zwischen der Beschichtungskammer (1) und jeder Quellenkammer (3, 3') ein trennwandförmiges Plattenventil (2, 2') angebracht ist.

3. Vakuumbeschichtungsanlage nach einem der vorangegangenen Ansprüche,
dadurch gekennzeichnet, daß ein Quellenkammer-Gehäuse (14, 14') lösbar mit dem Beschichtungskammer-Gehäuse (17) verbunden ist.

## Claims

1. A vacuum coating installation comprising an evacuatable coating chamber (1) for a substrate (13) to be coated and at least one source chamber (3, 3') connected thereto and holding a source (cathode 4) of the material for coating,
characterised in that the coating chamber (1) is separable in vacuum-tight manner from the plurality of individually evacuatable source chambers (3, 3') for various coating materials,
wherein the coating material in the source chamber (3, 3') is adapted to be evaporated by a pulsed arc discharge,
for which purpose a single laser (12) is provided and its laser beam (9, 9') is adapted to be directed by a tiltable mirror (10) on to the particular source chamber (3, 3') to be activated and on to the source of cathode material (cathode 4) therein.

2. A vacuum coating installation according to claim 1,
characterised in that a disc valve (2, 2') in the form of a partition is provided between the coating chamber (1) and each source chamber (3, 3').

3. A vacuum coating installation according to any of the preceding claims,
characterised in that a source-chamber casing (14, 14') is releasably connected to the coating-chamber casing (17).

## Revendications

1. Installation de dépôt sous vide comprenant une chambre de revêtement ou d'enduction (1) susceptible d'être mise sous vide pour recevoir un substrat à revêtir (13) et au moins une chambre à source (3, 3') communiquant avec la précédente pour une source de matière (cathode 4) pour la matière de revêtement,
caractérisée en ce que
la chambre de revêtement (1) est séparable de manière étanche au vide des chambres à source (3, 3'), prévues pour recevoir des matières de revêtement différentes, ces chambres à source (3, 3') étant mises sous vide séparément,
la matière de revêtement dans les chambres à source (3, 3') étant vaporisée par une décharge d'arc à commande impulsionnelle,
un seul laser (12) est prévu dont le faisceau (9, 9') est conduit par l'intermédiaire d'un miroir de renvoi (10, 10') sur chaque chambre à source (3, 3') différente et dans celle-ci sur la matière de la source cathodique (cathode 4).

2. Installation selon la revendication 1,
caractérisée en ce qu'
entre la chambre de revêtement (1) et chaque chambre à source (3, 3'), il est prévu une soupape à plaque à paroi mince (2, 2').

3. Installation selon l'une des revendications précédentes,
caractérisée en ce que
le corps de la chambre à source (14, 14') est relié de manière amovible au boîtier (17) de la chambre de revêtement.
